# EUROPÄISCHE PATENTSCHRIFT

(11) **EP 3 197 249 B1**
(45) Veröffentlichungstag und Bekanntmachung des Hinweises auf die Patenterteilung: **21.09.2022**
(21) Anmeldenummer: 16152127.3
(22) Anmeldetag: 20.01.2016
(51) Int. Cl.: H05K 3/00, G03F 7/20, H05K 3/06

(54) **DIREKTBELICHTUNGSEINRICHTUNG ZUR DIREKTBELICHTUNG VON LÖTSTOPPLACKEN IN 2-DIMENSIONALER, KURZZEITTEMPERIERTER UMGEBUNG**
DIRECT EXPOSURE DEVICE FOR DIRECT EXPOSURE OF SOLDERING STOP LAYERS IN TWO-DIMENSIONAL ENVIRONMENT WITH SHORT-TERM TEMPERING
DISPOSITIF D'EXPOSITION A LA LUMIERE DIRECTE DE VERNIS EPARGNE DANS UN ENVIRONNEMENT TEMPERE MOMENTANEMENT A 2 DIMENSIONS D'ECLAIRAGE DIRECT

(43) Veröffentlichungstag der Anmeldung: 26.07.2017
(73) Patentinhaber: Limata GmbH, 85737 Ismaning (DE)
(72) Erfinder: Nagel, Matthias, 85586 Poing (DE)
(74) Vertreter: Vossius & Partner Patentanwälte Rechtsanwälte mbB

(56) Entgegenhaltungen:
- EP-A2- 2 871 525
- DE-A1-102006 006 797

## Beschreibung

### Gebiet der Erfindung

Die vorliegende Erfindung betrifft allgemein eine Belichtungseinrichtung, insbesondere eine Direktbelichtungseinrichtung bzw. Lithografiebelichtungseinrichtung zum direkten Belichten eines mit einer lichtempfindlichen Schicht beschichteten Substrats zur Herstellung einer Leiterplatte bzw. Platine oder eines Formätzteiles, sowie das entsprechende Verfahren zur Belichtung mit der erfindungsgemäßen Direktbelichtungseinrichtung. Insbesondere betrifft die Erfindung eine Belichtungseinrichtung mit mindestens einem UV-Lichtstrahl, der durch eine veränderbare Ablenkeinrichtung relativ zum Substrat abgelenkt wird, um Strukturen in der lichtempfindlichen Schicht zu erzeugen. Vorzugsweise wird der Lichtstrahl von zwei oder mehr Laserstrahlen unterschiedlicher UV-Wellenlänge gebildet. Insbesondere wird dem Lichtstrahl eine räumlich begrenzte, vorzugsweise extern gelagerte Wärmequelle räumlich in der Bildebene und zeitlich in der Belichtung überlagert, wobei vorzugsweise Infrarotlaserdioden (IR-Laserdioden) mit Zeilenformoptiken als Wärmequelle verwendet werden.

### Hintergrund der Erfindung

Eine Leiterplatte (Leiterkarte, Platine) ist ein Träger bzw. Substrat aus isolierendem Material mit festhaftenden leitenden Verbindungen. Eine Leiterplatte dient der mechanischen Befestigung und elektrischen Verbindung elektronischer Bauteile. Die Verbindungsleitungen (Leiterbahnen) werden zumeist durch Masken-Ätzen (geätzte Leiterplatte, engl.: etched wiring board = EWB) aus einer dünnen Schicht leitfähigen Materials, beispielsweise Kupfer, auf einem isolierenden Substrat (dem sogenannte Basismaterial) hergestellt.

Bei der Erzeugung von Schaltstrukturen bzw. Verbindungsleitungen mittels Masken-Ätzen wird üblicherweise ein Schaltungsmuster auf einer Abdeckmaske bereitgestellt. Eine lichtempfindliche Schicht (Fotoresist bzw. Fotolack) die auf einem mit einer leitfähigen Beschichtung versehenen Plattenrohling aufgetragen ist, wird durch die Abdeckmaske belichtet, wodurch das Schaltungsmuster von der Abdeckmaske auf den Fotoresist übertragen wird.

Durch die Belichtung mit UV-Licht wird die Beschaffenheit des Fotolacks so verändert, dass die belichteten und unbelichteten Strukturen unterschiedlich von einer Entwicklerflüssigkeit lösbar sind. So können nach der Belichtung des Fotolacks durch die Maske mit dem gewünschten Platinenlayout, je nach verwendetem Fotolack, entweder die belichteten oder die unbelichteten Anteile des Lacks in einer passenden Entwicklerlösung gelöst und entfernt werden. Bringt man die so behandelte Leiterplatte in eine geeignete Ätzlösung (z. B. in Wasser gelöstes Eisen(III)-chlorid oder Natriumpersulfat oder mit Salzsäure+H₂O₂), so wird nur der freigelegte Teil der metallisierten Oberfläche angegriffen; die vom Fotolack bedeckten Anteile bleiben erhalten, weil der Lack beständig gegen die Ätzlösung ist.

Nachdem die Leiterbahnen der Leiterplatte ausgebildet wurden wird ein Lötstopplack aufgebracht. Der Lötstopplack einer fertigen Leiterplatte soll vorzugsweise so strukturiert sein, dass er die Leiterbahnen abdeckt und nur die Lötstellen frei lässt. Dieser Lötstopplack ist häufig als grüne Lackschicht auf der Leiterplatte ausgebildet. Synonym zum Begriff Lötstopplack werden auch die Begriffe Lötstoppmaske, Soldermask oder Stopplack verwendet. Durch den Lötstopplack lassen sich beispielsweise Lötfehler vermeiden; beim Schwalllöten spart man Zinn und die Leiterbahnen werden vor Korrosion geschützt. Die frei bleibenden Lötstellen (Pads und Lötaugen) können mit einem physikalischen Verfahren (hot air leveling) mit einer Zinnschicht und zusätzlich mit einem Flussmittel überzogen werden, die ein besseres Löten ermöglicht.

Lötstopplacke lassen sich grundsätzlich in zwei Gruppen unterteilen, die sich durch das Auftragsverfahren charakterisieren lassen. Die Auftragung erfolgt entweder strukturiert oder ganzflächig mit einer nachfolgenden Strukturierung mit phototechnischen Prozessen.

Im strukturierten Siebdruckverfahren wird der Lötstopplack beispielsweise mittels Rakel durch ein Sieb gepresst. Desweiteren ist es zunehmend auch möglich mittels Direktdruckverfahren Flüssiglacke strukturiert auf die Leiterplatte zu drucken, beispielsweise im Ink-Jet Druckverfahren.

Gemäß dem zweiten Verfahren wird der Lötstopplack durch Sprühen, Vorhanggießen, Walzenauftrag oder ein sonstiges Beschichten flächig auf die Leiterplatte aufgebracht. Die Strukturierung des Lötstopplacks, d.h., das Ausbilden eines Musters erfolgt anschließend mittels Belichtung. Insbesondere handelt es sich hier um sogenannte photostrukturierbare Lötstopplacke (LPI, liquid photoimageable soldermask). Typischerweise sind photostrukturierbare Lötstopplacke viskose Flüssigkeiten oder Photopolymer-Folien in der Art eines Trockenfilms. Nach dem Aufbringen werden sie vorzugsweise getrocknet, belichtet und anschließend entwickelt.

Vorzugsweise erfolgt die Bestrahlung bzw. Belichtung des Lötstopplacks mit UV-Licht von einer oder mehreren Wellenlängen. Bei der Belichtung von Lötstopplacken werden die belichteten Bereiche durch die Belichtung derart verändert, dass sie einen nachfolgenden Entwicklungsprozess überstehen. Diese Lötstopplacke werden häufig als UV-härtende Lötstopplacke bezeichnet.

Gemäß einer ersten Ausführungsform können nicht belichtete Bereiche des Lötstopplacks von einer Entwicklerflüssigkeit weggespült und/oder weggelöst werden. Gemäß einer anderen Ausführungsform können die belichteten Bereiche des Lötstopplacks von einer Entwicklerflüssigkeit weggespült und/oder weggelöst werden.

Der auf der Leiterplatte übrig gebliebene Lötstopplack verhindert, nach einem folgenden thermischen Backprozess, das Fortschwimmen der aufgelegten Bauteile bei dem nachfolgenden Reflowlötprozess. Ebenfalls schützt der Lötstopplack die geätzten Schaltungsstrukturen sowie das Basismaterial vor äußeren Einflüssen. Weiterhin können besondere Farben von Lötstopplack verwendet werden, um damit die Eigenschaften der Platine. z.B. die verbesserte Reflektion von Licht, zu steuern.

Aus dem Stand der Technik ist die Belichtung und die daraus erhaltene Härtung des Lötstopplacks mit Hilfe einer Maske bekannt (Maskenbelichtung; häufig auch Kontaktbelichtung genannt). Diese Lötstopplackhärtung mittels Maskenverfahrens hat den Vorteil im Hinblick auf Geschwindigkeit. Allgemein werden für die Lötstopplackbelichtung hohe Dosen an Lichtintensitäten im ultravioletten Wellenlängenbereich von 350 nm - 450 nm benötigt. Um in diesem spektralen Bereich ausreichend Licht-Leistung für die Belichtung erzielen zu können, wurden im konventionellen Maskenprozess die UV-Lampen bzw. UV-Lichtquellen speziell dotiert. Ein Nachteil dieser energiereichen UV-Lichtquellen waren hohe Verlustleistungen. Typische Brennerlampen bzw. Kontaktbelichtungsapparate benötigen eine Anschlussleistung von über 15 KWh, wobei die Hauptenergie auch nach der Brennerdotierung im Infraroten (IR) Spektralbereich liegt. Diese IR-Energie wird versucht soweit wie möglich zu minimieren, da sie das bildgebende Medium, die Maske, erwärmt und sich durch diese Erwärmung das Medium ausdehnt bzw. verändern kann. Es kommt folglich zu einer undefinierbaren, nicht linearen Skalierung der Maske und somit zu Abbildungsfehlern des Lötstopplackbildes. So verändert sich beispielsweise die Strukturgröße und führt zu Fehlern im Design der Leiterplatte, zum Anderen wirkt sich die nichtlineare Skalierung negativ auf die Passgenauigkeit des zu belichtenden Lötstopplacks zur bereits strukturierten Leiterbahn aus. Trotz zahlreicher Maßnahmen zur Eliminierung des IR-Spektrums erwärmen sich Leiterplatten und Maske im Kontaktbelichtungsapparat bei der Belichtung von Lötstopplacken, insbesondere bei der Belichtung von hochenergetischen Lötstopplacken z.B. der Farbe weiß. Aufgrund dessen wurden die ersten Kontaktbelichtungsapparate mit UV-LED Quellen ausgestattet, welche kein IR-Spektrum mehr besitzen. Dadurch werden voran beschriebene Effekte der Qualitätsminderung der Belichtung beim Maskenverfahren ausgeschlossen.

Eine Alternative zum Maskenverfahren ist die Direktbelichtung. Die Direktbelichtung besitzt die Eigenschaft, dass, anders als bei der konventionellen Maskenbelichtung, die zu belichtenden Strukturen ohne ein bildgebendes Mittel (Maske) mittels verschiedener Direktstrukturierungsverfahren eingebracht werden können. Der Vorteil dieser Technologie besteht in der Schnelligkeit der Bearbeitung ohne Verlustzeit bei der Fertigung von den Rüstmaterialien (z.B. Masken), sowie einer erhöhten Auflösungs- und Registrierungsqualität. Aus dem Stand der Technik ist beispielsweise eine Laser-Direktbelichtung bekannt, bei der der Laserstrahl mit Galvano-Scanner-Spiegelverfahren sowie Polygonscannverfahren abgelenkt wird. Zudem existieren Verfahren basierend auf Lichtmodulatoren mit Mikrospiegeltechnologien im Einsatz mit Laser- oder Leuchtdioden.

Bei der Direktbelichtung von Lötstopplacken kommen im Stand der Technik UV-Laser oder UV-Leuchtdioden zum Einsatz, welche nur zahlreich kaskadiert eine hohe Ausgangsleistung im Bildfeld der Belichtung erreichen können. Insbesondere ist es aus dem Stand der Technik bekannt, dass die Ausgangsleistung einer einzelnen UV-LED oder Laserdiode zu gering ist, um eine schnelle UV-Polymerisierung des Lötstopplacks zu erhalten. Daher werden im Stand der Technik mehrere Dioden zusammengeschalten (kaskadiert), um eine ausreichend hohe Energiedichte zu erhalten. Da eine einzelne Laserdiode jedoch teuer ist, wird bei zu hoher Kaskadierung die UV-Direktbelichtung zu teuer und damit nicht mehr wirtschaftlich.

Zudem sind auch andere Laser, die Licht im UV-Bereich ausstrahlen, teuer, sodass eine Belichtung mit UV-Licht mit einer hohen Lichtintensität entweder teuer und schnell, oder billig und langsam ist. Dazu ist es nicht allen Direktbelichtungstechnologien möglich, unbegrenzt hohe Lichtleistungen in die Bildebene zu transferieren, da Verlustleistungen an optischen Elementen zu hohen Temperatureinflüssen und folglich zu geringen Lebensdauer der Bauteile führen können.

Zudem wird auf die Patentanmeldung EP 2 871 525 verwiesen, in der die Anmelderin der vorliegenden Erfindung bereits Vorteile einer Lithografiebelichtungseinrichtung zum lithographischen direkten Belichten eines Musters auf einem Substrat beschrieben hat.

In der Anmeldung DE 10 2006 006797 wird ein Verfahren zur Belichtung ohne Maske beschrieben sowie eine Vorrichtung zur Belichtung ohne Maske mit stark gerichtetem Licht zur Beleuchtung bzw. Belichtung. Es besteht daher Bedarf an Lösungen, die aus technischer und wirtschaftlicher Sicht den Energiebedarf zur Belichtung des Lötstopplacks reduzieren.

Die Aufgabe wird durch ein erfindungsgemäßes Verfahren sowie eine erfindungsgemäße Vorrichtung gelöst, die in den entsprechenden unabhängigen Ansprüchen 7 bzw. 1 definiert sind. Weitere bevorzugte Ausführungsformen der Erfindung sind in den abhängigen Ansprüchen definiert.

Gemäß einem ersten Aspekt betrifft die vorliegende Erfindung eine Direktbelichtungseinrichtung zum direkten, vorzugsweise maskenlosen, Belichten und Härten einer gewünschten Struktur in einem UV härtbaren Lötstopplack Die erfindungsgemäße Vorrichtung kann beispielsweise auch für die Belichtung einer flüssigen Polymerverbindung verwendet werden, die mit UV-Licht härtbar ist.

Vorzugsweise kann die vorliegende Erfindung auch für Bestückungsdruck (oft auch als Bestückungsaufdruck genannt) verwendet werden. Bei einem Bestückungsdruck handelt es sich um eine Beschriftungsmethode von Leiterplatten. Der Bestückungsdruck im Stand der Technik wird üblicherweise im Siebdruck aufgebracht. Für Prototypen und Kleinserien existieren jedoch auch Methoden, welche dem Tintenstrahldruck ähnlich sind. Erfindungsgemäß kann für den Bestückungsdruck auch ein UV härtbarer Lack verwendet werden. Normalerweise werden die Umrisse der Bauelemente aufgedruckt, um das manuelle Bestücken zu erleichtern und so Fehler zu vermeiden. Oft werden die einzelnen Bauteile auch durchnummeriert, um diese, z. B. bei folgenden Reparaturarbeiten, mit Hilfe des Schaltplanes finden zu können. Als Farbe für die Druckfarbe sind Weiß und Gelb am verbreitetsten, prinzipiell sind jedoch auch andere Farben denkbar.

Die erfindungsgemäße Direktbelichtungseinrichtung umfasst mindestens eine Belichtungseinrichtung, die mindestens eine UV-Laserlichtquelle zur Erzeugung eines UV-Laserlichtstrahls aufweist. Zudem umfasst die erfindungsgemäße Direktbelichtungseinrichtung eine Ablenkeinrichtung, die dazu eingerichtet ist, den UV-Laserlichtstrahl auf eine Belichtungsebene zu lenken, um die gewünschte Struktur in einem Lötstopplack, der in der Belichtungsebene angeordnet ist, zu belichten und vorzugsweise zu härten. Die Direktbelichtungseinrichtung weist eine Wärmequelleneinrichtung auf, die so eingerichtet ist, dass ein Bereich in der Belichtungsebene räumlich und zeitlich überlappend von dem abgelenkten UV-Laserlichtstrahl und der von der Wärmequelleneinrichtung emittierenden Wärmestrahlung belichtet wird.

Vorzugsweise weist die Direktbelichtungseinrichtung zusätzlich eine Aufnahmeeinrichtung zur Aufnahme eines beschichteten Substrats auf. Vorzugsweise ist das Substrat mit einem UV härtbaren Lötstopplack beschichtet. Zudem ist es bevorzugt, wenn die Direktbelichtungseinrichtung mindestens eine Bewegungseinrichtung aufweist, um eine Relativbewegung zwischen der mindestens einen Belichtungseinrichtung und dem Substrat zu erzeugen.

Die mindestens eine Belichtungseinrichtung weist vorzugsweise mindestens zwei UV-Laserlichtquellen auf, vorzugsweise mindestens zwei UV-Laserdioden, die UV-Laserlicht in vorzugsweise zwei unterschiedlichen Wellenlängen im Bereich von 350 nm - 450 nm emittieren. Die Erfindung ist jedoch nicht auf zwei UV-Laserdioden beschränkt, d.h., es können auch mehrere gleiche und/oder unterschiedliche UV-Laserdioden vorgesehen sein. Erfindungsgemäß kann eine Kopplungsoptik verwendet werden, die dazu eingerichtet ist, Licht mehrerer UV-Laserlichtquellen zusammenzufassen, um das zusammengefasste UV-Laserlicht über die Ablenkeinrichtung auf die Belichtungsebene, insbesondere den Lötstopplack zu richten.

Vorzugsweise umfasst die Wärmequelleneinrichtung mindestens einen IR-Laser, der so mit der Direktbelichtungseinrichtung gekoppelt ist, dass vorzugsweise eine im Wesentlichen feste Belichtungsfläche in der Belichtungsebene erzeugt wird. Vorzugsweise belichtet der IR-Laser auf der Belichtungsfläche eine IR-Belichtungsfläche einer bestimmten geometrischen Form, beispielsweise ein Viereck, ein Parallelogramm, Trapez, Rechteck oder ein Oval bzw. einen Kreis. Zudem ist es bevorzugt, dass das Laserlicht der UV-Laserlichtquellen von der Ablenkeinrichtung so auf die Belichtungsebene abgelenkt wird, dass ein jeweils von dem UV-Laserlichtstrahl belichteter Punkt gleichzeitig von dem IR-Licht belichtet wird. Mit anderen Worten, vorzugsweise wird das Licht der UV-Laserlichtquellen so abgelenkt, dass sich die in Belichtungsebene belichteten Punkte innerhalb der Belichtungsfläche des IR-Lasers befinden.

Gemäß einer weiteren bevorzugten Ausführungsform kann die Belichtungsfläche während der UV-Laserlichtbelichtung auch verändert werden, z.B. vergrößert, verkleinert und/oder verschoben werden, wodurch sich ggf. eine Belichtungsfläche ergibt, die in Abhängigkeit der UV-Laserbelichtung optimiert ist.

Gemäß einer weiteren bevorzugten Ausführungsform kann die Direktbelichtungseinrichtung eine Vorrichtung aufweisen, zum Bereitstellen eines Inertgases unmittelbar oberhalb der Belichtungsebene, vorzugsweise oberhalb der Belichtungsfläche.

Zudem zeichnet sich die vorliegende Erfindung insbesondere durch das erfindungsgemäße Verfahren aus zum direkten, vorzugsweise maskenlosen, Belichten einer gewünschten Struktur in einem UV härtbaren Lack. Insbesondere bewirkt die erfindungsgemäße Belichtung eine effektive Belichtung mit einer effizienteren Härtung eines Lötstopplacks. Das erfindungsgemäße Verfahren umfasst die folgenden Schritte: Erzeugen eines UV-Laserlichtstrahl mit einer Belichtungseinrichtung und Ablenken des UV-Laserlichtstrahls auf eine Belichtungsebene in der der Lötstopplack angeordnet ist, um die gewünschte Struktur im Lötstopplack zu belichten (UV-Belichtung). Zudem ist gleichzeitig zur UV-Belichtung Wärmestrahlung von einer Wärmequelleneinrichtung auf den Lötstopplack zu richten, so, dass die UV belichteten Stellen gleichzeitig von UV und Wärmestrahlung belichtet werden. Mit anderen

Worten, die emittierte Wärmestrahlung überlappt räumlich und zeitlich mit dem auf die Belichtungsebene abgelenkten UV-Laserlichtstrahl, wodurch der abgelenkte UV-Laserlichtstrahl auf einen von der emittierten Wärmestrahlung erwärmten Bereich des Lötstopplacks trifft.

Die Wärmestrahlung ist vorzugsweise IR-Licht, das vorzugsweise von einem IR-Laser emittiert wird, der vorzugsweise eine im Wesentlichen geometrisch feste Belichtungsfläche in der Belichtungsebene erzeugt, wobei der abgelenkte UV-Laserlichtstrahl vorzugsweise innerhalb dieser festen von UV-Licht belichteten Belichtungsfläche abgelenkt wird.

Vorzugsweise umfasst der UV-Laserlichtstrahl mindestens zwei, vorzugsweise drei unterschiedliche Wellenlängen im UV-Bereich, vorzugsweise im Bereich von 350 nm - 450 nm.

Zudem kann es vorteilhaft sein, während der UV-Belichtung unmittelbar oberhalb der Belichtungsebene ein Inertgas bereitzustellen.

Generell kann die Aufgabe der vorliegenden Erfindung insbesondere dadurch gelöst werden, dass die UV-Belichtung bzw. UV-Härtung des Lötstopplacks durch gezielt eingebrachte Wärme unterstützt wird.

Generell empfehlen einige Hersteller von Lötstopplacken, dass die maximale Temperatur während der Belichtung 35°C nicht überschreiten sollte. Zudem führt eine allgemeine Wärmeeinbringung bei einem Präzisionswerkzeug, wie einer Direktbelichtungseinrichtung, zwangsläufig auch zur Erwärmung der Umgebungstemperatur und somit zu unerwünschten thermischen Ausdehnungseffekten in der Einrichtung selbst, z.B. des Aufbaus der Direktbelichtungseinrichtung, welcher z.B. Metall- oder Aluminiumteile aufweist. Eine generelle, vollflächige Erwärmung sollte somit vermieden werden, bzw. beeinflusst die Umgebung und somit die Genauigkeit der Anwendung negativ. Auch eine mittels Heizelementen generelle Erwärmung der Leiterplatte, auf der der zu strukturierende Lötstopplack aufgetragen ist, führt ebenfalls zu unerwünschten Ausdehnungseffekten. Diese könnten gegebenfalls durch eine nicht-lineare Skalierung der Daten zur Direktbelichtung korrigiert bzw. kompensiert werden, sodass bei einem vor dem eigentlichen Belichtungsprozess stattfindenden Registrierungsprozess, Ausdehnungseffekte punktuell erkannt und kompensiert werden. Dies ist jedoch nur für einen temperaturstabilen Prozess bzw. eine temperaturstabile Situation von wenigen Grad Schwankung möglich.

Zudem ist es neben der bevorzugten Genauigkeit einer Direktbelichtung weiter bevorzugt, eine hohe Durchsatzmenge zu erreichen, d.h., eine Belichtung einer mit Lötstopplack beschichteten Leiterplatte sollte möglichst wenig Zeit beanspruchen. Eine vollflächige Erwärmung einer kupferkaschierten und mit Lötstopplack überzogenen Platte (Standardgröße 610 mm x 457 mm) mit einem nicht zu aggressiven Temperaturprofil, um zu starke Verzüge zu vermeiden, würde eine zu lange Zeitperiode benötigen. Desweiteren wird die Vollflächenerhitzung stark von der Materialstärke sowie der Kupferstärke abhängig sein, so dass eine Vorabprüfung der exakten Plattenparameter notwendig wäre, welche in der Praxis mit Aufbautoleranzen der Galvanischen Prozesse teilweise zu hoch in den Fertigungstoleranzen sind.

Das hier aufgezeigte neue erfindungsgemäße Verfahren kombiniert die maskenlose Eigenschaft der Direktbelichtung von Leiterplatten mit Lötstopplacken mit der punktgenauen und hochenergetischen Zeilenerhitzung durch einen IR-Laser, vorzugsweise durch einen IR-Laser mit einem speziellen Spektrum. Der erfindungsgemäße IR-Laser ist vorzugsweise als externe Komponente an einer Belichtungseinrichtung angeordnet, vorzugsweise in Form eines Multi-Kopf Systems und erreicht dabei eine Art "Katalysations"-Wirkung der parallel zum Zeilenheizverfahren laufenden UV-Multiwellenlängen Polymerisierung. Das erfindungsgemäße Verfahren zeichnet sich insbesondere durch die gezielte Erwärmung aus, ohne weitere äußere Umgebungseinwirkungen auf die optischen und mechanischen Komponenten des Belichtungsapparates sowie ohne Flächenaufheizung des Trägermaterials. Zudem ist das erfindungsgemäße Verfahren vorzugsweise unabhängig von der Höhe (Stärke) der Kupferkaschierung.

In der dargestellten Verfahrensausführung mit einem Laserbelichter in Zeilenausführung wird der UV-polymerisierende und entsprechend des Leiterbildes modulierte Laserstrahl durch den externen IR-Zeilenlaserstrahl vollflächig überlagert und schafft somit eine begrenzte, stark erhitzte und zeitlich kurzfristig ideale Umgebungsbedingung für die Polymerisierung des Lötstopplacks.

Die Wirkung des IR-Lichts wird auf den geringen Zeilenabschnitt kurzfristig schnell und präzise abgestrahlt ohne weitere negative Einflüsse, welche, wie zuvor beschrieben, bei anderen Verfahren unausweichlich sind.

Eine relevante Wirkung der IR-Strahlung kann bei Energieeinträgen von 0,3 W/mm² bei Zeilenlängen von 80 mm und Zeilenbreiten von 1-2 mm erreicht werden. Dabei fällt die zuvor ohne IR-Erwärmung benötigte UV-Energie zur benötigten Endpolymerisierung um diverse Faktoren in Abhängigkeit des zu prozessierenden Lacksystems. Folgende Tabelle zeigt die Auswirkung einer erfindungsgemäßen IR-Bestrahlung der Energiedichte 0,4 W/mm² bei unterschiedlichen Lacken. Insbesondere wurde die benötigte UV-Energie in Bezug auf einen gewünschten "Grau-Wert" bestimmt, der gemäß eines bekannten Graustufenkeils einem definierten Grau-Wert. Beispielsweise bieten sogenannte Stouffer-Graustufenkeile (beispielsweise T2115) eine entsprechende Grau-Wert Einteilung.

| | | Benötigte UV-Energie ohne IR-Bestrahlung | Benötigte UV Energie mit IR-Bestrahlung von 0,4 W/mm² |
|---|---|---|---|
| **Lacksystem:** | **Lackfarbe:** | **Stouffer 10 klar** | **Stouffer 10 klar** |
| Sun Chemicals XV Serie | Blau | 600 mJ/cm² | 220 mJ/ cm² |
| Huntsmen Probimer | Grün | 700 mJ/ cm² | 250 mJ/ cm² |
| Peters Elpemer GL 2467 | Grün | 400 mJ/ cm² | 200 mJ/ cm² |

Dabei konnte gezeigt werden, dass die randscharfe Energiebegrenzung bzw. Flächenleistungsverteilung der Erwärmung durch die optischen Komponenten auf die Trägerplatte übertragen wird, so dass die IR-Strahlung nur punktgenau an diesen Stellen wirkt bzw. wirken kann.

### Zusammenfassung der Erfindung

Die erfindungsgemäße Direktbelichtungseinrichtung umfasst eine Belichtungseinrichtung zum Belichten eines Substrats mit lichtempfindlicher Schicht (beispielsweise Lötstopplack). Die Belichtungseinrichtung umfasst mindestens eine Lichtquelle, um Licht im UV-Wellenlängenbereich, vorzugsweise im Bereich zwischen 350 nm bis 450 nm abzustrahlen, d.h., vorzugsweise in dem Wellenlängenbereich in dem die lichtempfindliche Schicht sensitiv ist. Vorzugsweise wird das Licht mit einer oder mehreren UV-Laserdioden bzw. Halbleiterlasern erzeugt.

Insbesondere handelt es sich bei der erfindungsgemäßen Direktbelichtungseinrichtung um eine maskenlose Direktbelichtungseinrichtung, mit der Muster bzw. Strukturen aufgrund der Umlenkung des Laserlichtstrahls während der Belichtung direkt auf das Substrat, vorzugsweise den Lötstopplack, belichtet werden können.

Die Erfindung betrifft allgemein eine Direktbelichtungseinrichtung zum lithographischen direkten, vorzugsweise maskenlosen. Belichten und Härten eines Musters bzw. einer Struktur in einem Lötstopplack, der im UV-Bereich von 350 nm - 450 nm aushärtet. Die Direktbelichtungseinrichtung weist zumindest eine Belichtungseinrichtung, vorzugsweise mehrere Belichtungseinrichtungen auf, wobei jede Belichtungseinrichtung vorzugsweise eine modulierbare Lichtquelle aufweist mit einer oder mehreren UV-Laserlichtquellen, zur Erzeugung von UV-Laserlichts, vorzugsweise im Wellenlängenbereich von 350 nm - 450 nm, weiter bevorzugt mit einer Wellenlänge von 375nm, 395 nm und/oder 405nm. Vorzugsweise wird das UV-Laserlichts innerhalb und/oder außerhalb der Belichtungseinrichtung kollimiert, um ein kollimiertes Laserlicht zu erhalten. Die Kollimierung erfolgt beispielsweise mit Hilfe einer Kopplungsoptik. Zudem weist die Direktbelichtungseinrichtung auch eine veränderbare Ablenkeinrichtung auf, die geeignet ist, durch Ablenken des UV-Laserlichts, vorzugsweise durch Ablenken des kollimierten UV-Laserlichts das Muster auf dem Substrat zu belichten.

Eine veränderbare Ablenkeinrichtung kann vorzugsweise auf die Ablenkeinrichtung auftreffendes Licht in Abhängigkeit einer zeitlichen Steuerung in unterschiedlichen Winkeln ablenken. Hierzu kann im einfachsten Fall ein Spiegel dienen, der verschoben oder um eine Achse verstellbar/veränderbar ist. Vorzugsweise kann ein Spiegel aber um mindestens zwei Achsen bzw. zwei Ebenen verstellbar bzw. rotierbar sein. Gemäß weiteren bevorzugten Ausführungsformen können auch mehrere veränderbare Spiegel zur Ablenkung des Lichts dienen. Eine veränderbare Ablenkeinrichtung im Sinne der vorliegenden Erfindung kann auch mit Einrichtungen erfolgen, die nicht mechanisch veränderbar sind, sondern lediglich das Reflexionsverhalten verändern. Beispielsweise kann ein Akusto-optischer-Modulator (AOM) verwendet werden, mit dessen Hilfe sowohl die Intensität als auch die Frequenz von Laserstrahlen moduliert werden kann. Ebenfalls ist es möglich, mittels eines AOM die Richtung des Laserstrahls zu ändern.

Als eine weitere im Sinne dieser Erfindung beispielhafte Anwendungsform kann die veränderbare Ablenkeinrichtung mit mindestens einen rotierenden bzw. verkippbaren Polygonspiegel ausgeführt werden, um das UV-Laserlicht an verschiedene Positionen auf dem Substrat abzulenken. Gemäß einer weiteren Ausführungsform kann die veränderbare Ablenkeinrichtung einen ein- oder zwei-dimensionalen Galvanometerscanner aufweisen.

Eine weitere im Sinne dieser Erfindung beispielhafte Anwendungsform kann die Abbildung durch Mikrospiegelanordnungen auf Halbleiterbasis erfolgen.

Zudem ist es bevorzugt, wenn die Lichtquelle bzw. Laserdiode modulierbar ist, d.h., sie kann vorzugsweise sowohl auf 0%, 100% geschaltet werden und weiter bevorzugt auf beliebige Zwischenstufen ihrer Leistung geschaltet werden. Dies ermöglicht beispielsweise eine bessere, konturgetreue Abbildung von Kanten und schrägen Bahnen.

Gemäß einer weiteren bevorzugten Ausführungsform kann die Belichtungseinrichtung zusätzlich an einer Bewegungseinrichtung angebracht sein, wobei die Bewegungseinrichtung eine Relativbewegung zwischen der Belichtungseinrichtung und dem Substrat erzeugt. Vorzugsweise ist jedoch das Substrat in Bezug zur Umgebung fixiert und die Bewegungseinrichtung bewegt die Belichtungseinrichtung relativ zum Substrat. Im Folgenden soll das ebene Substrat in einer XY-Ebene liegen, wobei die Belichtungseinrichtung durch die Bewegungseinrichtung vorzugsweise in einer Ebene parallel zur XY-Ebene bewegt werden kann (vorzugsweise stehen X-Achse und Y-Achse senkrecht zueinander). Weiter bevorzugt kann die Belichtungseinrichtung durch die Bewegungseinrichtung auch entlang einer zur XY-Ebene senkrechten Z-Achse (vorzugsweise parallel zur Gravitationskraft) bewegt werden. Mit anderen Worten, die Bewegungseinrichtung ist vorzugsweise angepasst, um eine Relativbewegung in einer Dimension, vorzugsweise parallel zum Substrat bzw. senkrecht zum Substrat zu ermöglichen, und/oder eine Relativbewegung in zwei Dimensionen, vorzugsweise parallel zum Substrat, zu ermöglichen, und/oder eine Relativbewegung in drei Dimensionen, vorzugsweise parallel und senkrecht zum Substrat zu ermöglichen.

Gemäß einer bevorzugten Ausführungsform weist die Belichtungseinrichtung mindestens zwei UV-Laserlichtquellen auf, vorzugsweise mindestens zwei UV-Laserdioden. Zudem ist es bevorzugt, dass zwei UV-Laserlichtquellen bzw. UV-Laserdioden Laserlicht einer unterschiedlichen Wellenlänge emittieren, wobei beide Wellenlängen vorzugsweise im Bereich von 350 nm - 450 nm liegen. Es ist aber auch möglich, dass zwei UV-Laserlichtquellen bzw. UV-Laserdioden Licht in der gleichen Wellenlänge emittieren, dies kann beispielsweise vorteilhaft sein, um die Leistung der Laserlichtquellen bzw. UV-Laserdioden zu erhöhen. Zudem ist es auch möglich, mehr als zwei UV-Laserlichtquellen bzw. UV-Laserdioden bereitzustellen, wobei vorzugsweise mindestens zwei oder mehr Lichtquellen Licht in unterschiedlichen Wellenlängen emittieren.

Um das gewünschte Muster auf dem Substrat in einer gewünschten Größe zu belichten, kann zudem eine Bildbearbeitungsvorrichtung für bildverarbeitende Maßnahmen vorgesehen sein, sodass mittels Skalierung, Drehung. Verschiebung und/oder Verkippung das zu belichtende Muster auf dem Substrat verändert bzw. korrigiert werden kann.

Um eine genaue und sichere Belichtung bereitzustellen werden erfindungsgemäß die Lichtstrahlen der mehreren Lichtquellen, vorzugsweise der UV-Laserlichtquellen bzw. UV-Laserdioden, mit Hilfe eines optischen Elements zu einem gemeinsamen Lichtstrahl kombiniert. Dieser gemeinsame Lichtstrahl kann dann mit Hilfe der veränderbaren Ablenkeinrichtung auf das Substrat gelenkt werden, als ob der Strahl von einer einzigen Lichtquelle kommt.

Vorzugsweise wird das zu belichtende Substrat nur von einer Seite, vorzugsweise von oben, mit der erfindungsgemäßen Direktbelichtungseinrichtung belichtet. Gemäß einer weiteren bevorzugten Ausführungsform kann das Substrat auch von zwei Seiten, beispielsweise von oben und unten bzw. der Seite, beispielsweise von rechts und links belichtet werden. So kann beispielsweise mindestens eine Belichtungseinrichtung oberhalb des Substrats angeordnet sein und mindestens eine Belichtungseinrichtung unterhalb des Substrats angeordnet sein, wobei die beiden Belichtungseinrichtungen vorzugsweise unabhängig voneinander bewegt werden können.

Neben der oben diskutierten Vorrichtung betrifft die Erfindung auch ein Verfahren zum lithographischen direkten, vorzugsweise maskenlosen, Belichten eines Musters auf einem Substrat, das eine lichtempfindliche Schicht im UV-Bereich von 350 nm - 450 nm aufweist, mit dem Schritt des Bereitstellens einer Direktbelichtungseinrichtung mit mindestens einer Belichtungseinrichtung, die eine modulierte Lichtquelle mit einer oder mehreren UV-Laserlichtquellen aufweist, vorzugsweise zur Erzeugung eines kollimierten UV-Laserlichts im Wellenlängenbereich von 350 nm - 450 nm. Anschließend wird das Substrat relativ zur Direktbelichtungseinrichtung so angeordnet, dass das von der Belichtungseinrichtung emittierte UV-Laserlicht auf das Substrat gelenkt werden kann. Dann wird das Substrat mit der Belichtungseinrichtung belichtet, wobei das Muster mittels einer veränderbaren Ablenkeinrichtung durch zeitlich variables Ablenken und/oder Modulieren des UV-Laserlichts auf dem Substrat erreicht wird.

Der Abstand zwischen Belichtungseinrichtung und Substrat kann vorzugsweise während der Belichtung verändert werden, wodurch sich dann die Ausdehnung eines auf dem Substrat erzeugten Belichtungsflecks vorzugsweise verändert, wodurch unterschiedlich breite Linien auf dem Substrat belichtet werden.

Die variable Ablenkeinrichtung lenkt das Licht vorzugsweise in den zwei Dimensionen zum Substrat ab, wobei dieser zeitlich variable Ablenkvorgang vorzugsweise mit zwei gleichen Oszillationsfrequenzen durchgeführt wird, um unter 45° parallele Linien zu scannen, wodurch die Scangeschwindigkeit um den Faktor √2 erhöht werden kann. Mit anderen Worten, die Ablenkgeschwindigkeit der Scanner kann dadurch gesteigert werden, dass sie nicht unter 90° zu der Bewegungsrichtung einer Linearmechanik arbeiten (eine schnelle und eine langsame Scanachse), sondern beide unter 45° mit der gleichen Geschwindigkeit scannen. Relativ bewegt sich der Laserpunkt durch diese Arbeitsweise schneller, benötigt allerdings auch mehr Laserleistung, um entsprechend auszuhärten.

Die Geschwindigkeit der Bewegungseinrichtung zur Erzeugung einer Relativbewegung zwischen der Belichtungseinrichtung und dem Substrat ist vorzugsweise an die Scan-Geschwindigkeit der variablen Ablenkeinrichtung angepasst, sodass die Relativbewegung der Belichtungseinrichtung zum Substrat in Abhängigkeit der Scan-Geschwindigkeit durchgeführt wird.

Die variable Ablenkeinrichtung hat vorzugsweise für eine Ablenkung entlang einer Y-Achse, die in der Ebene des Substrats liegt, eine erste Spiegelstufe in Form eines Galvanometerspiegel und vorzugsweise für eine Ablenkung entlang einer X-Achse, die in der Ebene des Substrats liegt und senkrecht zur Y-Achse liegt, eine zweite Spiegelstufe, vorzugsweise in Form eines eindimensionalen elektrisch-magnetisch oszillierenden Mikrospiegels.

Gemäß einer weiteren bevorzugten Ausführungsform kann die erste und/oder zweite Spiegelstufe vorzugsweise in Form eines ein- bzw. zweidimensional arbeitenden Polygonscanners gestaltet sein.

Gemäß einer weiteren bevorzugten Ausführungsform kann die erste und/oder zweite Spiegelstufe vorzugsweise in Form eines ein- bzw. zweidimensional Galvanometerspiegels ausgestaltet sein.

Gemäß einer weiteren bevorzugten Ausführungsform kann die erste und/oder zweite Spiegelstufe vorzugsweise in Form eines ein- bzw. zweidimensional MEM-Spiegels (Micro Electromechanical Mirror; MEM) ausgestaltet sein. MEMs sind elektromechanisch arbeitendes Spiegelsysteme, die aus mikroskopisch kleinen Spiegeln bestehen, die in optischen Schalter den Lichtstrahl schalten.

Gemäß einer weiteren bevorzugten Ausführungsform kann die erste und/oder zweite Spiegelstufe vorzugsweise in Form eines Mikroscanners (englisch micro-scanner bzw. microscanning mirror) ausgestalted sein. Ein Mikroscanner ist ein mikro-opto-elektromechanisches System (MOEMS) aus der Klasse der Mikrospiegelaktoren zur dynamischen Modulation von Licht. Je nach Bauart kann die modulierend wirkende Bewegung eines Einzelspiegels translatorisch oder um eine bzw. zwei Achsen rotatorisch erfolgen. Im ersten Fall wird eine phasenschiebende Wirkung, im zweiten Fall, die Ablenkung der einfallenden Lichtwelle erzielt.

Vorzugsweise ist die Belichtungseinrichtung in mehrfacher Anwendung nebeneinander so zueinander aufgebaut, dass sich beim Scanvorgang eine geschlossene, um die Anzahl der Belichtungseinrichtungen multiplizierte Scanlinien ergibt. Gelingt es durch eine besonders integrierte Bauweise die Belichtungseinheiten so aufzubauen, dass z.B. bei vier Einheiten die einzelnen Scanbereiche sich nahtlos aneinander reihen, ergibt sich eine durchgehende Scanlinie. In der normalen, bisherigen Arbeitsweise ist dies nicht möglich, weswegen mindestens zwei Fahrten (vor und zurück) durchgeführt werden müssen.

Vorzugsweise ist die Belichtungseinrichtung mit einer Strahlaufweitungsoptik versehen, um das UV-Laserlicht, vorzugsweise das kollimierte UV-Laserlicht, auf einen größeren, definierten Durchmesser aufzuweiten.

Vorzugsweise kann die eine oder können die mehreren UV-Laserdioden analog elektrisch, vorzugsweise in Abhängigkeit der Grau-Stufen-Werte der Abbildung einer Einspeisequellen moduliert werden.

Gemäß einer weiteren bevorzugten Ausführungsform kann die eine oder können die mehreren UV-Laserdioden digital elektrisch, vorzugsweise in Abhängigkeit der Grau-Stufen-Werte der Abbildung der Einspeisequellen moduliert werden.
Schließlich kann erfindungsgemäß durch die Überlappung projizierter Einzelbilder und/oder die Schwärzung bzw. Nichtbelichtung überstehender Randbereiche eine Anpassung der Einzelbilder vorzugsweise in der Einspeisequelle vor dem Belichtungsvorgang erfolgen. Zur voran beschriebenen Arbeitsweise umfasst die erfindungsgemäße Direktbelichtungseinrichtung eine vorzugsweise extern angebrachte Komponente zur räumlich begrenzten und zeitlich synchronisierten Wärmeeinbringung in der Bildebene durch vorzugsweise Infrarot Halbleiter Hochleistungs-Dioden mit Zeilenformoptik durch Überlagerung der UV-polymerisierenden Lichtstrahlen mit der homogenen Erhitzungsfläche. Vorzugsweise wird der Infrarotlaser durch eine Faserzuführung an die Direktbelichtungseinrichtung im Schrägwinkel angebracht.

Erfindungsgemäß wird der kollimierte IR-Laserstrahl durch Homogenisierungsoptiken vorzugswiese Mikrolinsenanordnungen sowie Zeilenoptiken in eine Fläche von vorzugweise 2 mm Breite und 80 mm Zeilenlänge transformiert.

Zudem betrifft die Erfindung auch eine mechanische Ausrichteanordnung in den Richtungen X und Y auf der Bildebene sowie die Brennweitennachstellung in Z und den Rotationswinkel α der Zeilenlaserfläche.

Gemäß einer weiteren bevorzugten Ausführungsform kann die eine oder können die mehreren IR-Laserdioden digital elektrisch, vorzugsweise in Abhängigkeit der Grau-Stufen-Werte der Abbildung der Einspeisequellen moduliert werden.

Schließlich kann die Wärmequelle zur hochgenauen Wärmedosiseinbringung einerseits per Pulsweitenmodulation als auch per CW Dauerstrich Methode betrieben werden.

Gemäß einer weiteren bevorzugten Ausführungsform kann die Wärmequelle bei benötigten relevanten Leistungserhöhungen kaskadiert aufgebaut werden, vorzugsweise durch Laserfaserkopplung von mehreren Einzeldiodenlasern.

Gemäß einer weiteren bevorzugten Ausführungsform kann zudem die Wärmequelle aus mehreren Infrarot Wellenlängen in vorzugsweise einem Einzelstrahl bzw. einer Einzelfläche kombiniert werden, um verschiedene Lackebenen bei dicken Lackschichten gleichförmig erhitzen zu können.

Vorzugsweise variable Linsen bzw. Optikelemente können in den Strahlengang bzw. Wärmetransmissionskanal eingebracht werden, um die räumliche Beschaffenheit der Wärmeverteilung, Wärmefläche und Fokusebene in der Bildebene dynamisch vorzugsweise softwaretechnisch gesteuert anpassen zu können.

### Kurze Beschreibung der Zeichnungen

Im Folgenden werden bevorzugte Ausführungsformen der vorliegenden Erfindung unter Bezugnahme auf die Figuren ausführlich beschrieben. Es zeigen:
- Fig. 1: perspektivische Ansicht einer erfindungsgemäßen Direktbelichtungseinrichtung mit einer externen Wärmequellenanordnung;
- Fig. 2: perspektivische Ansicht einer erfindungsgemäßen Direktbelichtungseinrichtung mit einer externen Wärmequellenanordnung in Form einer Zwei-Achs-Portalanordnung mit einer vierstufigen Projektionseinheit in der Belichtungseinrichtung; und
- Fig. 3: eine schematische Darstellung der Überlappung der UV Laserlinie der Belichtungseinrichtung mit der Zeilenfläche einer externen Wärmequellenanordnung.

### Detaillierte Beschreibung bevorzugter Ausführungsformen

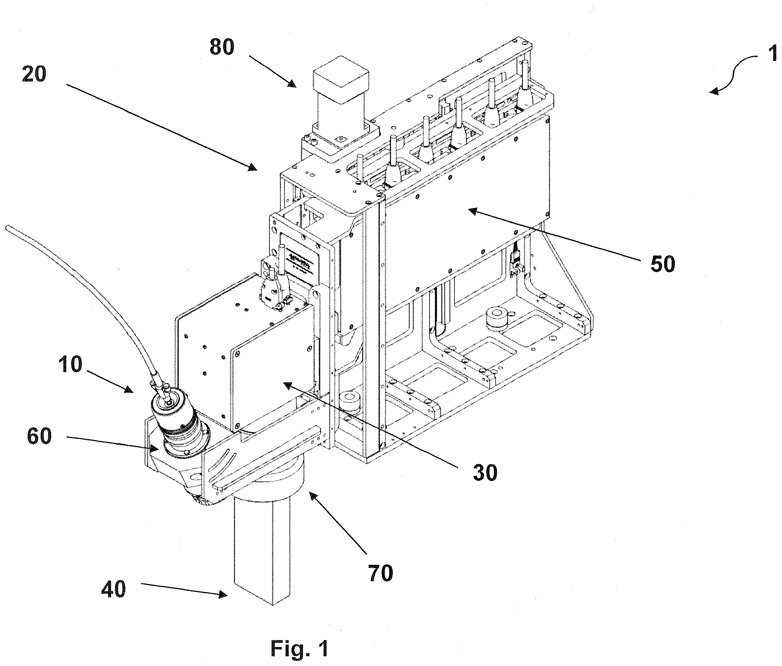

Figur 1 zeigt eine perspektivische Ansicht einer erfindungsgemäßen Direktbelichtungseinrichtung 1 (im Folgenden auch als Lithografiebelichtungseinrichtung genannt) mit einer Belichtungseinrichtung 20 und einer externen Wärmequelleneinrichtung 10. Beispielsweise kann die Wärmequelleneinrichtung 10 über eine Justiereinrichtung 60 an der Belichtungseinrichtung 20 montiert sein.

Dieser Aufbau umfasst vorzugsweise ein Laserdioden-Modul mit Kopplungsoptiken 50 mit transmittierenden Laserlichtstrahlen im ultravioletten Spektralbereich von 350 nm - 450 nm. Vorzugsweise findet die Kopplung innerhalb des Lasermoduls statt und wird durch optische Elemente vom Stand der Technik durchgeführt. Hierzu werden z.B. Polwürfel und halbdurchlässige Spiegel sowie andere Kombinationsoptiken hergenommen. Vorzugsweise werden Laser mit diskreten Single Mode Wellenlängen mit verschiedenen Hauptmaxima in der Kopplungsoptik 50 gekoppelt bzw. kombiniert. Beispielsweise können die Lichtstrahlen von drei Laserquellen mit Hauptmaxima bei ca. 375 nm, 390 nm und 405 nm gekoppelt werden.

Die Einzelstrahlen bzw. die gekoppelten Strahlen der UV Laserlichtquellen, bei denen es sich vorzugsweise um Laserdiodenquellen handelt, werden über eine Ablenkeinrichtung (im Folgenden auch Laserablenkeinrichtung 30 genannt) auf die Belichtungsebene 40 abgebildet. Vorzugsweise liegt die zu belichtende Fläche in der Belichtungsebene 40 oder im Wesentlichen parallel zur Belichtungsebene 40. Vorzugsweise soll erfindungsgemäß die mit einem Lötstopplack beschichtete Fläche eines Substrats bzw. einer Leiterplatte 100 belichtet werden.

Bei der Laserablenkeinrichtung 30 kann es sich beispielsweise um einen Galvanoscanner mit UV-Wellenlängen reflektierender Spiegelbeschichtung handeln, der vorzugsweise über ein achromatisches, telezentrisches F-Theta Objektiv 70 auf die Belichtungsebene 40 bzw. Fokalebene abbildet. Der in Figur 1 dargestellte Quader unterhalb des Objektivs 70 stellt den Arbeitsbereich des Objektives 70 dar. Gemäß einer weiteren bevorzugten Ausführungsform kann der Arbeitsbereich auch kleiner oder größer bzw. breiter sein.

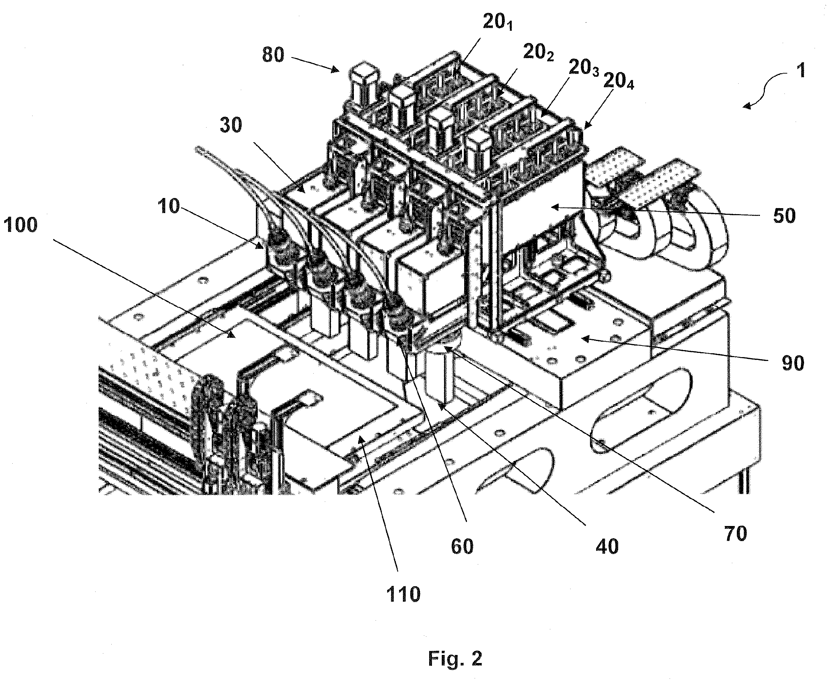

Figur 2 zeigt eine perspektivische Ansicht einer weiteren erfindungsgemäßen Direktbelichtungseinrichtung 1 mit vier Belichtungseinrichtungen 20₁. 20₂, 20₃ und 20₄. Jede dieser vier Belichtungseinrichtungen 20ₓ ist zudem mit einer externen Wärmequelleneinrichtung 10ₓ gekoppelt, die wiederum über entsprechende Justiereinrichtungen 60ₓ an den Belichtungseinrichtungen 20ₓ montiert sind.

Zudem zeigt die Figur 2 die Montage der Belichtungseinrichtungen 20 an einer Bewegungseinrichtung 90. Mit Hilfe der Bewegungseinrichtung 90 wird eine Relativbewegung zwischen der Belichtungseinrichtung 20 und dem zu belichtenden Substrat 100 erzeugt, wodurch größere Flächen eines Substrats 100 belichtet werden können.

Die erfindungsgemäße Direktbelichtungseinrichtung kann alternativ oder zusätzlich eine zweite Bewegungseinrichtung 110 aufweisen. Die zweite Bewegungseinrichtung 110 kann vorzugsweise als Vakuumtisch ausgeführt sein, auf dem das Substrat 100 mittels Unterdruck anbringbar ist. Die Bewegung der zweiten Bewegungseinrichtung 110 kann beispielsweise eine Bewegung in der x-y-Ebene bereitstellen, vorzugsweise parallel zur Belichtungsebene. Die Bewegung kann mittels Elektromotor bzw. Elektromotoren erfolgen, vorzugsweise mittels Linearmotoren mit entsprechenden Führungen.

Mit Hilfe der Bewegungseinrichtung bzw. der Bewegungseinrichtungen können die Belichtungseinrichtungen 20 die Belichtungsebene kaskardierend abfahren, vorzugsweise kaskardierend in Spaltcnform abfahren. Mit anderen Worten, eine Parallelisierung mit mehreren Belichtungseinheiten ist möglich.

Dabei kann die fokale Ebene bzw. die Belichtungsebene 40 durch integrierte Stellmotoren 80, die eine Bewegung der Belichtungseinrichtungen 20 entlang der z-Achse erlaubt, nachjustiert werden. Vorzugsweise erfolgt eine Justierung der Belichtungsebene 20 vor dem Belichtungsprozess.

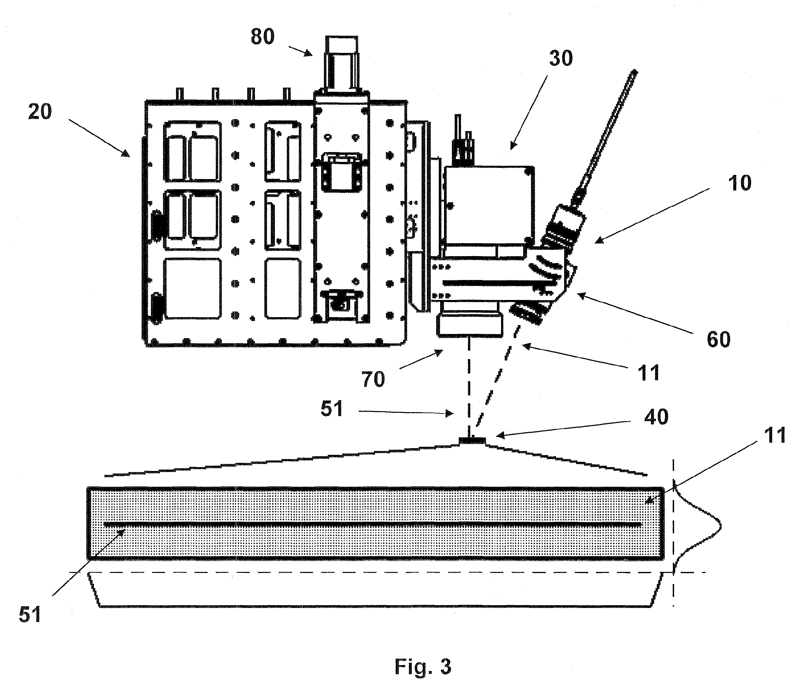

Figur 3 zeigt eine schematische Seitenansicht einer erfindungsgemäßen Belichtungseinrichtung 20 mit einer externen Wärmequellenanordnung 10, die in dieser Ausführungsform mit über eine Justiereinrichtung 60 an der Belichtungseinrichtung 20 montiert ist.

Der Strahlengang 51 des emittierten UV-Lasers auf der Belichtungsebene ist in der Figur 3 nicht maßstabsgerecht, rein schematisch dargestellt. Beispielsweise wird der UV-Laserstrahl mit Hilfe der Ablenkeinrichtung 30, bei der es sich vorzugsweise um ein Galvanoscanner System 30 handelt, entlang einer Zeile bzw. Spalte abgelenkt. Der Strahlengang 51 ist erfindungsgemäß auf der Belichtungsebene mit dem IR-Laserstrahl überlagert. Insbesondere ist es bevorzugt, dass das von der Wärmequelleneinrichtung 10 ausgestrahlte Licht auf der Belichtungsebene 40 im Wesentlichen eine rechteckige Belichtungsfläche 11 darstellt, und entlang einer Richtung eine Gaußförmige Lichtintensitätsverteilung aufweist.

Dabei wird die modulierte und somit strukurierende UV-Laserstrahllinie 51 vorzugsweise 1-6 Strahlen mit einer typischen Laserliniendimension von 80 mm Breite und vorzugsweise 5-25 µm Höhe (FWHM, Gausssches Intensitätsprofil) direkt zentrisch über das Wärmefeld 11 des IR Laserstrahl durch die Justiereinrichtung 60 positioniert.

Das Intensitätsprofil des dabei entstehenden Wärmefeldes 11 ist vorzugsweise rechteckförmig, stark abfallend und vorzugsweise durch Linsenanpassungen in zwei Dimensionen angepasst. Vorzugsweise findet eine Top-Hat Intensitätsprofilverteilung in der Breite sowie eine Gausssche Intensitätsprofilverteilung in der Höhe statt. Die Auslegung der Wärmefelddimensionen sind vorzugweise sowohl in der Breite als auch in der Höhe größer als die UV-Laserstrahllinie 51 auszulegen. Dabei ist vorzugsweise auf eine Breite von ca. 85 mm und eine Höhe von ca. 2 mm zu achten, so dass die Temperaturvariation im Bereich der UV-Laserstrahllinie 51 zweidimensional homogen verteilt ist.

### Bezugszeichen und Begriffe:

- 1: Direktbelichtungseinrichtung, Lithografiebelichtungseinrichtung (das gesamte System)
- 5: Lötstopplack
- 6: Substrat
- 10: Wärmequelleneinrichtung, Wärmequelle
- 11: Belichtungsfläche, Wärmefeld
- 20: Belichtungseinrichtung (das "Laser-System" mit den UV Lasern)
- 30: Ablenkeinrichtung, Laserablenkeinrichtung
- 40: Belichtungsebene, Belichtungsebene (x-y-Ebene)
- 50: Kopplungsoptik
- 51: Strahlengang
- 60: Justiereinrichtung
- 70: Objektiv
- 80: Stellmotoren
- 90: erste Bewegungseinrichtung
- 100: Leiterplatte, Substrat
- 110: zweite Bewegungseinrichtung

## Patentansprüche

1. Direktbelichtungseinrichtung (1) zum direkten, vorzugsweise maskenlosen, Belichten und Härten einer gewünschten Struktur in einem Lötstopplack (5) mit:
mindestens einer Belichtungseinrichtung (20), die mindestens eine UV-Laserlichtquelle zur Erzeugung eines UV-Laserlichtstrahls aufweist, und
einer Ablenkeinrichtung (30), die dazu eingerichtet ist, den UV-Laserlichtstrahl auf eine Belichtungsebene (40) abzulenken, um die gewünschte Struktur in dem Lötstopplack (5), der in der Belichtungsebene (40) angeordnet ist, zu belichten,
**dadurch gekennzeichnet, dass**
die Direktbelichtungseinrichtung (1) eine Wärmequelleneinrichtung (10) mit Homogenisierungsoptiken aufweist, wobei die Wärmequelleneinrichtung (10) so eingerichtet ist, dass ein Bereich (11) in der Belichtungsebene (40) räumlich homogen und zeitlich überlappend von dem abgelenkten UV-Laserlichtstrahl (51) und der von der Wärmequelleneinrichtung (10) emittierten Wärmestrahlung belichtet wird.

2. Direktbelichtungseinrichtung nach Anspruch 1, zusätzlich mit einer Aufnahmeeinrichtung zur Aufnahme eines mit Lötstopplack (5) beschichteten Substrats (100) und mindestens einer Bewegungseinrichtung (90, 110) zur Erzeugung einer Relativbewegung zwischen der mindestens einen Belichtungseinrichtung (20) und dem Substrat (100).

3. Direktbelichtungseinrichtung nach Anspruch 1 oder 2, wobei die mindestens eine Belichtungseinrichtung (20) mindestens zwei UV-Laserlichtquellen, vorzugsweise mindestens zwei UV-Laserdioden aufweist, die UV-Laserlicht (13) in mindestens zwei unterschiedlichen Wellenlängen im Bereich von 350 nm - 450 nm emittieren.

4. Direktbelichtungseinrichtung nach einem der vorhergehenden Ansprüche, wobei die Wärmequelleneinrichtung (10) mindestens einen IR-Laser aufweist, der so mit der Direktbelichtungseinrichtung (1) gekoppelt ist, dass eine im Wesentlichen feste Belichtungsfläche (11) in der Belichtungsebene (40) erzeugt wird, und der von der Ablenkeinrichtung (30) abgelenkte UV-Laserlichtstrahl (51) innerhalb der Belichtungsfläche (11) abgelenkt wird.

5. Direktbelichtungseinrichtung nach einem der vorhergehenden Ansprüche, zusätzlich mit einer Vorrichtung zum Bereitstellen eines Inertgases unmittelbar oberhalb der Belichtungsebene (40), vorzugsweise oberhalb der Belichtungsfläche (11).

6. Direktbelichtungseinrichtung nach einem der vorhergehenden Ansprüche, mit einer Kopplungsoptik (50) die dazu eingerichtet ist, Licht mehrerer UV-Laserlichtquellen zusammenzufassen, um UV-Laserlicht über die Ablenkeinrichtung (30) auf den Lötstopplack (5) zu richten.

7. Verfahren zum direkten, vorzugsweise maskenlosen, Belichten und Härten einer gewünschten Struktur in einem Lötstopplack (5) mit den Schritten:
Erzeugen eines UV-Laserlichtstrahl mit einer Belichtungseinrichtung (20),
Ablenken des UV-Laserlichtstrahls auf eine Belichtungsebene (40) in der der Lötstopplack (5) angeordnet ist, um die gewünschte Struktur im Lötstopplack (5) zu belichten,
**gekennzeichnet durch**,
Emittieren von Wärmestrahlung einer Wärmequelleneinrichtung (10) mit Homogenisierungsoptiken auf den Lötstopplack (5), wobei die emittierte Wärmestrahlung räumlich **homogen und zeitlich** mit dem auf die Belichtungsebene (40) abgelenkten UV-Laserlichtstrahl überlappt, wodurch der abgelenkte UV-Laserlichtstrahl auf einen von der emittierten Wärmestrahlung erwärmten Bereich des Lötstopplacks (5) trifft.

8. Verfahren nach Anspruch 7, wobei der UV-Laserlichtstrahl mindestens zwei, vorzugsweise drei unterschiedliche Wellenlängen im UV Bereich aufweist, vorzugsweise im Bereich von 350 nm - 450 nm.

9. Verfahren nach Anspruch 7 oder 8, wobei die Wärmestrahlung IR-Licht ist, das vorzugsweise von einem IR-Laser emittiert wird, der vorzugsweise eine im Wesentlichen geometrisch feste Belichtungsfläche (11) in der Belichtungsebene (40) erzeugt und der abgelenkte UV-Laserlichtstrahl (51) innerhalb dieser Belichtungsfläche (11) abgelenkt wird.

10. Verfahren nach einem der Ansprüche 7 -9, wobei während der Belichtung unmittelbar oberhalb der Belichtungsebene (40) ein Inertgas vorhanden ist.

## Claims

1. A direct exposure device (1) for direct, preferably maskless, exposure and curing of a desired structure in a solder resist (5) comprising:
at least one exposure device (20) which comprises at least one UV laser light source for generating a UV laser light beam, and
a deflection device (30) which is configured to deflect the UV laser light beam to an exposure plane (40) in order to expose the desired structure in the solder resist (5) which is arranged in the exposure plane (40),
**characterized in that**
the direct exposure device (1) comprises a heat source device (10) comprising homogenization optics, wherein the heat source device (10) is configured such that an area (11) in the exposure plane (40) is exposed, spatially homogenously and in a way overlapping in terms of time, to the deflected UV laser light beam (51) and to the heat radiation emitted by the heat source device (10).

2. The direct exposure device according to claim 1, additionally comprising an accommodation device for accommodating a substrate (100) coated with a solder resist (5), and at least one movement device (90, 110) for generating relative movement between the at least one exposure device (20) and the substrate (100).

3. The direct exposure device according to claim 1 or 2, wherein the at least one exposure device (20) comprises at least two UV laser light sources, preferably at least two UV laser diodes, which emit UV laser light (13) in at least two different wavelengths in the range of 350 nm - 450 nm.

4. The direct exposure device according to any one of the preceding claims, wherein the heat source device (10) comprises at least one IR laser which is coupled to the direct exposure device (1) such that a substantially fixed exposure area (11) is generated in the exposure plane (40) and the UV laser light beam (51) deflected by the deflection device (30) is deflected within the exposure area (11).

5. The direct exposure device according to any one of the preceding claims, additionally comprising a device for providing an inert gas directly above the exposure plane (40), preferably above the exposure area (11).

6. The direct exposure device according to any one of the preceding claims, comprising coupling optics (50) which are adapted to combine light of a plurality of UV laser light sources in order to direct UV laser light via the deflection device (30) onto the solder resist (5).

7. A method for the direct, preferably maskless, exposure and curing of a desired structure in a solder resist (5) comprising the following steps:
generating a UV laser light beam with an exposure device (20),
deflecting the UV laser light beam onto an exposure plane (40) in which the solder resist (5) is located in order to expose the desired structure in the solder resist (5),
**characterized by**
emitting heat radiation of a heat source device (10) comprising homogenization optics onto the solder resist (5), wherein the emitted heat radiation is spatially homogenous and overlaps in terms of time with the UV laser light beam deflected onto the exposure plane (40), whereby the deflected UV laser light beam hits an area of the solder resist (5) that has been heated by the emitted heat radiation.

8. The method according to claim 7, wherein the UV laser light beam comprises at least two, preferably three, different wavelengths in the UV range, preferably in the range of 350 nm - 450 nm.

9. The method according to claim 7 or 8, wherein the heat radiation is IR light which is preferably emitted by an IR laser which preferably generates a substantially geometrically fixed exposure area (11) in the exposure plane (40), and the deflected UV laser light beam (51) is deflected within this exposure area (11).

10. The method according to any one of claims 7 to 9, wherein there is an inert gas directly above the exposure plane (40) during the exposure.

## Revendications

1. Dispositif d'exposition directe à la lumière (1) pour l'exposition directe à la lumière de préférence sans masque et pour le durcissement d'une structure souhaitée dans une réserve de soudure (5), avec :
au moins un dispositif d'exposition à la lumière (20), qui présente au moins une source de lumière laser UV pour produire un faisceau de lumière laser UV, et
un dispositif de déviation (30) qui est mis au point pour dévier le faisceau de lumière laser UV sur un plan d'exposition à la lumière (40) pour exposer à la lumière la structure souhaitée dans la réserve de soudure (5), qui est disposée dans le plan d'exposition à la lumière (40),
**caractérisé en ce que**
le dispositif d'exposition directe à la lumière (1) présente un dispositif de source de chaleur (10) avec des optiques d'homogénéisation, dans lequel le dispositif de source de chaleur (10) est mis au point de telle sorte qu'une zone (11) est exposée à la lumière dans le plan d'exposition à la lumière (40) de manière homogène spatialement et en se chevauchant dans le temps par le faisceau de lumière laser UV (51) dévié et le rayonnement thermique émis par le dispositif de source de chaleur (10).

2. Dispositif d'exposition directe à la lumière selon la revendication 1, en plus avec un dispositif de logement pour loger un substrat (100) revêtu de réserve de soudure (5) et au moins un dispositif de déplacement (90, 110) pour produire un déplacement relatif entre l'au moins un dispositif d'exposition à la lumière (20) et le substrat (100).

3. Dispositif d'exposition directe à la lumière selon la revendication 1 ou 2, dans lequel l'au moins un dispositif d'exposition à la lumière (20) présente au moins deux sources de lumière laser UV, de préférence au moins deux diodes laser UV, qui émettent une lumière laser UV (13) dans au moins deux longueurs d'onde différentes dans la plage de 350 nm - 450 nm.

4. Dispositif d'exposition directe à la lumière selon l'une quelconque des revendications précédentes, dans lequel le dispositif de source de chaleur (10) présente au moins un laser IR qui est couplé de telle sorte au dispositif d'exposition directe à la lumière (1) qu'une surface d'exposition à la lumière (11) sensiblement fixe est produite dans le plan d'exposition à la lumière (40) et le faisceau de lumière laser UV (51) dévié du dispositif de déviation (30) est dévié à l'intérieur de la surface d'exposition à la lumière (11).

5. Dispositif d'exposition directe à la lumière selon l'une quelconque des revendications précédentes, avec en plus un système pour fournir un gaz inerte directement au-dessus du plan d'exposition à la lumière (40), de préférence au-dessus de la surface d'exposition à la lumière (11).

6. Dispositif d'exposition directe à la lumière selon l'une quelconque des revendications précédentes, avec une optique de couplage (50) qui est mise au point pour regrouper de la lumière de plusieurs sources de lumière laser UV pour diriger la lumière laser UV par l'intermédiaire du dispositif de déviation (30) sur la réserve de soudure (5).

7. Procédé pour l'exposition directe à la lumière, de préférence sans masque, et pour le durcissement d'une structure souhaitée dans une réserve de soudure (5), avec les étapes :
de production d'un faisceau de lumière laser UV avec un dispositif d'exposition à la lumière (20),
de déviation du faisceau de lumière laser UV sur un plan d'exposition à la lumière (40), dans lequel la réserve de soudure (5) est disposée pour exposer à la lumière la structure souhaitée dans la réserve de soudure (5),
**caractérisé par**
l'émission d'un rayonnement thermique d'un dispositif de source de chaleur (10) avec des optiques d'homogénéisation sur la réserve de soudure (5), dans lequel le rayonnement thermique émis est homogène dans l'espace et chevauche dans le temps le faisceau de lumière laser UV dévié sur le plan d'exposition à la lumière (40), ce qui a pour effet que le faisceau de lumière laser UV dévié arrive sur une zone, réchauffée par le rayonnement thermique émis, de la réserve de soudure (5).

8. Procédé selon la revendication 7, dans lequel le faisceau de lumière laser UV présente deux, de préférence trois différentes longueurs d'onde dans la plage UV, de préférence dans la plage de 350 nm - 450 nm.

9. Procédé selon la revendication 7 ou 8, dans lequel le rayonnement thermique est de la lumière IR, qui est émise de préférence par un laser IR, qui produit de préférence une surface d'exposition à la lumière (11) sensiblement géométriquement fixe dans le plan d'exposition à la lumière (40) et le faisceau de lumière laser UV (51) dévié est dévié à l'intérieur de ladite surface d'exposition à la lumière (11).

10. Procédé selon l'une quelconque des revendications 7 - 9, dans lequel un gaz inerte est présent, au cours de l'exposition à la lumière, directement au-dessus du plan d'exposition à la lumière (40).
